# EUROPEAN PATENT SPECIFICATION

(11) **EP 3 948 924 B1**
(45) Date of publication and mention of the grant of the patent: **07.06.2023**
(21) Application number: 20714231.6
(22) Date of filing: 31.03.2020
(51) Int. Cl.: H01J 37/32, H01J 37/34

(54) **MAGNET BAR STRUCTURE WITH ATTACHED SENSOR**
MAGNETSTANGESTRUKTUR MIT ANGEHÄNGTEM SENSOR
STRUCTURE DE BARRE D'AIMANT AVEC CAPTEUR ATTACHÉ

(30) Priority: 05.04.2019 BE 201905222
(43) Date of publication of application: 09.02.2022
(73) Proprietor: Soleras Advanced Coatings BV, 9800 Deinze (BE)
(72) Inventor: HUMBLE, Francis Taylor, Scarborough, 04074 (US); DE BOSSCHER, Wilmert, 9031 Drongen (BE); VAN DE PUTTE, Ivan, 8790 Waregem (BE)
(74) Representative: DenK iP bv
(86) International application number: PCT/EP2020/059174
(87) International publication number: WO 2020/201309

(56) References cited:
- EP-A1- 2 626 887
- US-A1- 2015 262 798
- US-A1- 2016 376 695
- US-A1- 2018 211 825

## Description

### Field of the invention

The invention relates to the field of sputtering deposition. More specifically it relates to magnet bar structures for tubular targets used in such sputtering deposition.

### Background of the invention

Physical vapor deposition by means of sputtering has become a standard technique to customize the properties of, for example, glass panes or other rigid or flexible materials. 'Sputtering' refers to the ballistic ejection of coating material atoms out of a target by means of positively charged ions, - usually argon - that are accelerated by an electric field towards a negatively charged target. The positive ions are formed by impact ionization in the low-pressure gas phase. The ejected atoms impinge on the substrate to be coated where they form a dense, well adhering coating.

The ionization of the gas forming the ions is confined close to the surface of the target by means of a magnetic field generated from behind the target surface and exhibiting an arc shaped, closed loop tunnel at the surface of the target. During operation, electrons bounce back and forth along those magnetic field lines while drifting down the closed loop thereby increasing the impact ionization probability of the gas atoms. A plasma glowing closed loop 'race track' forms at the surface of the target.

Generally, rotatable targets are preferred in many cases despite technical challenges arising from the presence of moving parts. Rotatable targets typically carry much more usable target material stock than planar targets do. They are less prone to arcing and may handle higher power levels compared to their planar counterparts. These advantages are particularly appreciated in inline coaters wherein substrates pass by the elongated, cylindrical target in a direction perpendicular to the axis of the target.

Medium and large-scale manufacturing plants utilize many different targets, which need to be stored and properly tracked. The targets need to be installed in chambers (e.g. vacuum chambers) in a lengthy process that is considered not productive. If a target is damaged, is of limited quality, or a wrong target is installed, and the sputtering process is started, substrate material is wasted. Moreover, using wrong targets or overlooking damages in a target may cause damage to the vacuum system itself. It would be desirable to reduce the risk of waste of substrate material and damages to the system due to using damaged or inadequate targets in a coater.

Document EP 2 626 887 A1 discloses a sputtering apparatus wherein an end-block is used for rotatably carrying a sputtering target, and wherein a magnet bar comprises a sensor for generating a sensor signal representative of a position or the magnetic field strength of a magnetic configuration and adapted for transferring the sensor signal towards the end-block.

Documents US 2018/211825 A1 and US 2016/376695 A1 disclose RFID tags and transducers, respectively, which are affixed to the backing plate of a planar sputtering target for target identification and lifetime monitoring purposes.

Document US 2015/262798 A1 discloses monitoring devices respectively coupled to a planar sputtering target and to the corresponding magnetron in order to identify and/or control said target and/or magnetron or the PVD process.

### Summary of the invention

The invention is defined by the claims.

It is an object of embodiments of the present invention to provide a magnet bar structure including sensing capabilities which can allow determining the properties, quality and/or identity of a tubular target.

Embodiments of the present invention provide a magnet bar structure for a sputter magnetron system. The magnet bar structure comprises a magnet bar and a sensing device, wherein the sensing device is attached to the magnet bar structure for sensing intrinsic and/or extrinsic properties of a tubular sputtering target when mounted on the sputter magnetron system, over the magnet bar structure.

It is an advantage of embodiments of the present invention that target information can be obtained, related to the identification, status and/or quality of the target, upon mounting the target to the sputter magnetron system. Quality and status information and changes can be obtained from the target, even during use thereof, e.g. even during rotation of the target, but not, however, limited thereto.

The magnet bar structure in accordance with embodiments of the present invention may further comprise signal transmission means for transmitting signals from the sensing device to a receiver outside of the magnet bar structure, for example, but not limited thereto, outside of the sputter magnetron system. It is an advantage of such embodiments of the present invention that target information can be processed and stored outside the magnetron system, allowing e.g. exporting the information to a different system.

In the magnet bar structure in accordance with embodiments of the present invention, the sensing device may be adapted to sense the presence of cracks and/or pores in the tubular sputtering target.

In the magnet bar structure in accordance with embodiments of the present invention, the sensing device may be adapted to sense the regularity of the inner and/or outer diameter of the tubular sputtering target and/or the curvature in the longitudinal direction of the tubular sputtering target. Measuring the inner and outer diameter of the tubular sputtering target for instance allows measuring target wall thickness.

In the magnet bar structure in accordance with embodiments of the present invention, the sensing device may comprise an ultrasonic transducer and/or an optical sensor. An ultrasonic transducer can advantageously be used to detect thickness of the target. It is an advantage of embodiments of the present invention that the sensing element can detect the presence of cracks.

In the magnet bar structure in accordance with embodiments of the present invention, the sensing device may comprise an inductive proximity sensor.

In the magnet bar structure in accordance with embodiments of the present invention, the sensing device may be adapted for sensing identification information of the tubular sputtering target. It is an advantage of embodiments of the present invention that the sensing device can identify the target, reducing the risk of using a wrong target in a sputtering process.

In particular embodiments, where the sensing device may comprise an optical reader for reading a bar code on the tubular sputtering target.

In particular embodiments, the sensing device may be an identification reader for reading an identification tag. It is an advantage of embodiments of the present invention that the tag can be shielded from the environment, because the tag can be read through electromagnetic fields. The identification reader may be a radio-frequency identification reader/writer. The magnet bar structure may then further comprise means for receiving signals from the outside of the sputter magnetron system for writing and/or overwriting a radio-frequency identification tag. It is an advantage of embodiments of the present invention that the magnet bar can introduce information related to the history of the target in the RFID tag of the target.

In the magnet bar structure in accordance with embodiments of the present invention, the sensing device may comprise a temperature sensor. The temperature sensor can for example be a thermocouple or IR radiation sensor. By means of a temperature sensor, for instance the target inner surface temperature can be measured, or the heat exchange towards the cooling fluid.

In the magnet bar structure in accordance with embodiments of the present invention, the sensing device may comprise one or more of a strain gauge, a CCD array.

In the magnet bar structure in accordance with embodiments of the present invention, the sensing device may comprise a plurality of sensing elements. In particular embodiments, the magnet bar structure may be elongated in a longitudinal direction, and the plurality of sensing elements may be distributed along said longitudinal direction. It is an advantage of embodiments of the present invention that ID tags and/or properties of a tubular target can be sensed from a plurality of points, optionally any point of the tubular target.

In embodiments of the present invention, all sensing elements may be of a same type. Alternatively, at least two of the sensing elements are of a different type.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG 1 illustrates a magnet bar structure including a sensing device in accordance with embodiments of the present invention.
FIG 2 illustrates the zones of interaction with the surfaces of the tubular target for monitoring the impact of process surroundings on the tubular target
FIG 3, FIG 4, FIG 5 and FIG 6 illustrate the cross sections of four different tubular targets installed and surrounding a magnet bar, where the tubular target of FIG 3 is symmetric, the tubular target of FIG 4 is bent, the tubular target of FIG 5 is crushed, the outer diameter of the tubular target of FIG 6 is symmetric, but the inner diameter is not, and hence the material thickness is not.
FIG 7 illustrates a magnet bar structure including a sensing device in accordance with embodiments of the present invention, for reading a tab in a tubular target.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Physical vapor deposition, or sputtering, is a commonly used process for depositing material on a substrate. The material to be deposited is contained in a target generally disposed adjacent to a substrate area, all in a vacuum chamber. The substrate area is the area where a substrate is located during the sputter coating process of that specific target. A gas is provided to the chamber, and an electric potential applied to ionize the gas into a plasma. The ions are generated close to the target by having a magnetic field provided by permanent magnets disposed in a convenient relationship to the target. The ions are accelerated towards and collide with the target, dislodging particles that may travel towards the substrate.

Where in embodiments of the present invention reference is made to "tubular sputtering target", or simply "target", reference is made to an elongated tube made of, or covered with, target material for sputtering, which has a hollow shape. The tubular sputtering target may optionally include a backing tube whereon the target material is provided, so the tubular sputtering target has an outer surface with target material to be sputtered, and an inner surface with a backing tube as support.

Coaters, specifically for instance coaters with tubular sputtering targets, are magnetron sputtering systems which usually include a vacuum chamber, and a substrate holder for positioning a substrate to be coated in the vacuum chamber. The vacuum chamber comprises a gas system for introducing process and/or carrier gases into the vacuum chamber.

At least one end block is provided in the vacuum chamber. The primary function of the end block is to carry the target. The end block may be configured to revolve the target around an axis of rotation. As sputtering is performed under a low gas pressure, the end block must be gastight at all times and surely when it is rotating. As the sputtering of the target generates a lot of heat on the target surface, the target must be cooled which is normally done with water or another suitable coolant or cooling fluid. This coolant must be fed and evacuated through the end block. Also, the target must be fed with an electrical current in order to maintain the target above a certain electric potential. Again this electrical current must pass through the end block. In order to incorporate all these functions, an end block may comprise different means.
A.) A drive means (e.g. a driver) to make the target rotate, e.g. worm-gear system, or a cylindrical gear-gear system or a conical gear-gear crossed axis system, or a pulley-belt system, or any other means known in the art to make the target rotate.
B.) An electrical contact means (e.g. a rotatable contact, a connector) to provide electrical current to the target. This may be achieved by means of an electrical commutator equipped with brushes that are in sliding contact with a commutator ring. Instead of a brush- and-ring arrangement, also two rings sliding against each other can be used, or a conducting belt type of connection can be used such as a metallic belt. The latter solution conveniently combines the drive means radial to the electrical contact means.
C.) Bearing means, for example a bearing. Depending on the weight of the target, more than one bearing may be necessary. The person skilled in the art will readily select that type of bearings that are appropriate from the different types known such as ball bearings, roller bearings, plain bearings, axial bearings or any other type known in the art.
D.) At least one coolant seal, e.g. rotatable coolant seal. These coolant seals ensure that coolant will not leak into the end block or - even worse - into the vacuum chamber while fixed and rotatable parts of an end block turn relative to one another. In order to reduce this risk, a number of coolant seals are introduced in cascade. Typically lip seals are used as coolant seal as they are well known in the art. However, other types - without being exhaustive - of seals like mechanical face seals or labyrinth seals are not excluded.
E.) Finally at least one vacuum seal, such as a rotatable vacuum seal, can be included. These vacuum seals ensure the integrity of the vacuum while fixed and rotating parts of the end block rotate relative to one another. A cascading series of vacuum seals - progressively protecting the vacuum - is preferred in order reduce the risk of having a vacuum leak. Again different seals are known, of which the lip seal is most popular, although other types of seals - such as ferrofluidic seals - can of course be used as well.

The at least one end block is not only adapted for rotatably carrying the tubular target, but also for rotatably restraining a magnet bar inside said sputtering target tube. Hereto, the end block comprises a receptacle for receiving a magnet bar fitting. The magnet bar comprises a plurality of magnets, optionally enclosed in a housing. The magnet bar, in use, is mechanically connected to the end block and, when in operation, is surrounded by a tubular sputtering target. Proximity of the magnets to the target and to the plasma interacting with the target affects the deposition rate. Reducing the distance between the magnets and the portion of the target adjacent to the magnets incrementally strengthens the interaction between the magnetic field of the magnets and the plasma adjacent to the target. This interaction strengthens the attraction of charged particles to the target, increasing sputtering and deposition on the substrate in the vicinity.

The present invention provides a magnet bar structure for use with a tubular sputtering target in a sputter magnetron system, that not only contains the magnets for magnetron sputtering, but also includes a sensing device for assisting at least during installation, and/or property and/or quality and/or status inspection of the target, and may also improve properties, quality and/or status monitoring, e.g. utilization monitoring, of the target or of impact from processes surrounding the target.

In a first aspect, the present invention relates to a magnet bar structure for a sputter magnetron system. The magnet bar structure comprises a magnet bar with a sensing device attached thereto, for example within the magnet bar, or embedded or on its housing or mounted on a part of the magnet bar, for sensing intrinsic and/or extrinsic properties of a tubular sputtering target when the latter is mounted on the end block, thus surrounding the magnet bar structure. The sensing device may comprise one or more sensing elements. The one or more sensing elements may be suitable for sensing properties of a tubular sputtering target when this target is rotating, but the present invention is not limited thereto; the sensing elements may also be suitable for sensing properties of the tubular sputtering target in rest. The sensing device may comprise a plurality of sensing elements for sensing different properties of the sputtering target. The sensing of different properties of the sputtering target may be done simultaneously or subsequently.

The terminology "intrinsic properties of the tubular sputtering target" refers to properties of the tubular sputtering target which are present, regardless of the sputtering process or condition, such as for instance, but not limited thereto:
- dimensional information of the tubular sputtering target (e.g. inner and outer diameter, thickness, length, roundness, bow, roughness, ...)
- mechanical information of the tubular sputtering target (e.g. brittleness, elasticity, density of target material, of the bonding/interface, of the backing tube,...)
- composition of the target material
- morphology, microstructure, ... of the target material
- conductivity (e.g. electrical, magnetic, thermal, ...) of the target material
- production information and QC data of the sputtering target
- marking related to intrinsic target properties (e.g. a code for reading or writing information to/from the target product); this marking can be mechanical, electrical, magnetic, optical, radiative, ...

The terminology "extrinsic properties of the tubular sputtering target" refers to properties of the tubular sputtering target being affected by the process or conditions of operation, such as for instance, but not limited thereto:
- temperature of the target, e.g. including temperature gradient across and along the target
- movement of the target (e.g. rotation speed, wobble (e.g. when having a bow and being rotated), ...)
- heat transfer of the target, for example the amount of energy exchange with the internal cooling fluid (e.g. by conduction) or with the external environment (e.g. by radiation).
- outer surface condition of the target; e.g. change of chemical properties (e.g. metallic, oxidic, nitride, ... as being impacted by the (e.g. reactive) sputter process and/or chamber condition and/or gas partial pressures)
- outer surface condition of the target; e.g. change of radiation geometry and field distribution, for example thermal, electrical, magnetic,... as being impacted by movements in the chamber (e.g. substrate or carrier) or by using additional sources (heaters, ion sources, additional coating sources, ...) or by presence and/or perturbations of energetic particles in the chamber (e.g. ions, electrons, exited atoms, ...).
- impact of the cooling fluid on the inner surface of the tubular target, for example flow regime, physical (e.g. temperature, flow rate, electrical conductivity...) and/or chemical (e.g. anti-algae additions, pH balancing chemicals, ...) properties of the fluid.
- pressure load (e.g. from inside from cooling liquid, or from outside)
- combined load on the target (e.g. total amount of rotation cycles or sputter cycles performed, sputter energy (e.g. kWh lifetime), heat histogram, time since production,...)
- use information and process flow chart
- marking with respect to extrinsic target properties (e.g. code for reading or writing information to/from the target product); this can be mechanical, electrical, magnetic, optical, radiative, ...

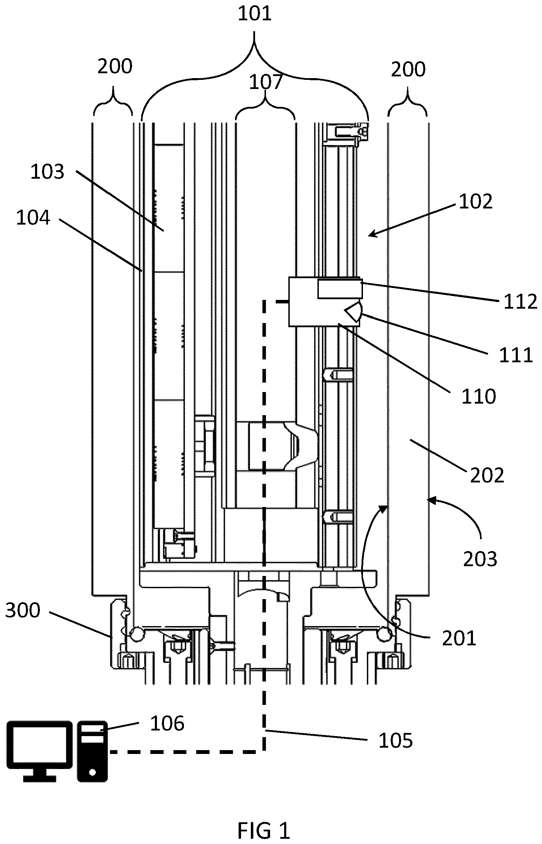

FIG 1 shows a magnet bar structure 101 and a surrounding tubular target 200, being held by an end block 300 (only partially shown). The magnet bar structure of FIG 1 comprises a magnet bar 102, including magnets 103 which, in the embodiment illustrated, are enclosed by a housing 104 (the present invention not being limited thereto), and a sensing device 110. The sensing device 110 may be placed within or on the magnet bar 102, or embedded in the housing 104, for example attached on or in the housing wall 104, or mounted on a part of the magnet bar system, e.g. a central tube 107, or optionally protruding from the magnet bar 102 as shown in the figure. At least part of the sensing device 110 may be protected from the environment of the magnet bar structure 101, e.g. from potentially damaging interaction with cooling fluids.

The sensing device 110 includes at least one sensing element 111. The sensing device may comprise a single sensing element. Alternatively, the sensing device 110 may include a plurality of sensing elements, of same or different type, for measuring same or different intrinsic or extrinsic properties of the sputtering target. At least two of the plurality of sensing elements may measure properties of the target at substantially the same location, or at different locations.

In embodiments of the present invention, a sensing element 111 may comprise a sensor adapted to measure, directly or indirectly, an intrinsic or an extrinsic property of the target 200, for example to determine its status and/or quality, and possible degradation thereof e.g. due to use. For instance, the sensing element 111 may detect the presence of pores and/or microcracks, for estimating the surface quality and smoothness of the target. In some embodiments, the size of such defects can also be determined. In embodiments of the present invention, the sensing element may be a temperature sensor, for instance an infrared sensor for sensing the temperature of the target, e.g. by measuring the temperature of the inside or backing tube of the tubular target, or any type of temperature sensor for sensing the temperature of the cooling liquid, as the temperature of the cooling liquid will be a measure for the temperature of the target. Different types of sensing elements for measuring different types of intrinsic or extrinsic properties of the target are known to the person skilled in the art.

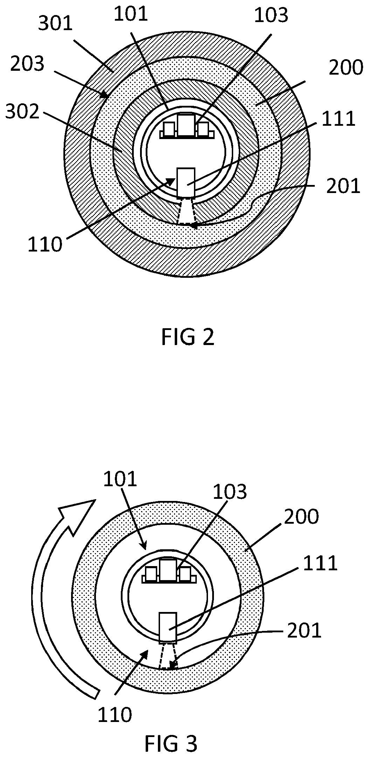

FIG 2 shows a cross section of a tubular target 200 and a magnet bar structure 101 in accordance with embodiments of the present invention, the cross section showing the sensing device 110 comprising a sensing element 111 receiving information from a portion of the inner surface 201 of the tubular target 200. The impact (or influence on the target) of the extrinsic properties can be measured on the target.

For example, processes occurring in the outer region 301 surrounding the outer surface 203 as described above have an impact on the tubular target, and such impact can be sensed with the sensing device 110, for example by measuring changes of the surface morphology, for example by ultrasonic measurements, e.g. by detecting changes of the shape of an ultrasonic reflection peak; for example by measuring target potential, e.g. once the electrical conductivity of the cooling fluid between the sensing element 111 and the tubular target 200 is known.

Analogously, processes occurring in the zone 302 between the inner surface 201 of the target and the sensing element can also have an impact on the tubular target. As before, the sensing element may detect this impact, for example changes in the flow regime of the cooling fluid, physical and/or chemical changes on the tubular target 200, etc.

Back to FIG 1, in particular embodiments, the sensing device 110, e.g. the one or more sensing elements 111, may be simply attached to the magnet bar 102, for instance, but not limited thereto, to the housing 104 thereof, for example by screwing, welding or gluing, which enables easy installation of the sensing elements 111 and fast adaptation of existing magnet bars 102, preferably without degrading the quality and performance characteristics of the magnet bar structure 101.

The sensing device 110 may be adapted to interchange signals with, e.g. receive signals from or provide signals to, the outside world, being the world outside the magnet bar. For example, the magnet bar structure 101 may include other elements, such as a signal transmitter 105, for example a wired or a wireless signal transmitter for signal output and/or input.

The sensing device 110 may comprise a signal emitter or signal source 112 for emitting signals to the target 200 or parts thereof. The signal source 112 may be adapted to emit a signal to impinge the inner surface 201 of the target 200, when mounted, and a corresponding sensing element 111 to capture returning information from the target, for instance, but not limited thereto, from the inner surface thereof. For example, the magnet bar structure 101 may comprise a signal source, in particular for example a light source 112 for illuminating the inner surface of the target, and an optical sensor as sensing element 111 for detecting the radiation reflected from the inner surface 201 of the target 200. In some embodiments of the present invention the radiation source and the receiving sensor may be integrated in a single device. In some embodiments of the present invention, a radiation source 112 may be absent and the sensing device 110 may be limited to a sensing element 111 only.

The present invention is not limited to optical sensors. Other types of sensors can be used as sensing element 111, for example an ultrasonic sensor, e.g. an ultrasonic transducer, can be used to detect the presence of cracks in the target in case the target comprises a backing tube, which would block optical signals. Additionally, the ultrasonic sensor may be adapted to detect cracks embedded in the target body 202, and/or on the target inner surface 201, and/or on the target outer surface 203, so the overall target quality can be determined. Detection of cracks may include analyzing the echoes and changes of direction thereof, for instance due to presence of surfaces of cracks. In case the sensing element 111 is an ultrasonic transducer, it may be adapted to provide ultrasonic signals, and/or an extra signal source 112, being an ultrasonic emitter, can be included.

In some embodiments, an ultrasonic sensing element 111 can alternatively or additionally be used to measure the thickness of the target 200, by analyzing the delay of the signal echoed at the surfaces (inner surface 201, outer surface 203, possible interface between backing tube and target material (not shown in the figures)) of the tubular target. The time delay is proportional to the distance between the sensor and the surfaces of the target. Time delay of the ultrasonic signals reflected at the surfaces of the target is influenced by the speed of sound in the target material of the target body 202 (and any other material in between the signal source and the sensing element) and by the thickness of the material. If the material is known, the remaining target material thickness can be measured, even during sputtering. The time delay can provide the thickness of the whole structure and thickness of the target material. The skilled person can take into account the thickness of extra surfaces, such as backing tubes or the like.

The measured thickness of the target may thus be an intrinsic property of the target, measured e.g. when the target is just mounted, but it may also be an extrinsic property, measured and changing during the sputter process. This allows measuring or at least estimating the available material on a target 200 at any moment, even when the target 200 is not easily reachable (e.g. during sputtering, in the vacuum coater, ...) and it may allow defining whether the target is suitable for further processing.

Layer thickness calculation accuracy using ultrasound sensing in accordance with embodiments of the present invention may be better than 1 mm; most systems can achieve distance measurement accuracy of 0.1 mm, and some systems can even give accuracy of even 0.01 mm under controlled conditions.

In some embodiments, the ultrasonic transducer for sensing thickness of the target may utilize a specific frequency within the range of 0.1 to 20 MHz, but the present invention is not limited thereto and may use frequencies up to 200 MHz. The frequency, as well as other parameters of the transducer such as its size, can be chosen to optimize focal depth and measurement accuracy.

In some embodiments, the transducer is focused, improving measurement of nominal thickness. It may be unfocussed, increasing the area of detection.

In embodiments of the present invention, the sensing element 111 may be in direct contact with the tubular target 200, or spaced therefrom by an intermediate element (delay line) or by a liquid, e.g. cooling liquid.

In some embodiments, the magnet bar structure 101 may comprise a plurality of sensing elements 111, e.g. a plurality of transducers, in special configurations, for example, in a Time-of-Flight diffraction configuration, or in a phased array configuration.

In particular embodiments, a sensing element 111 can be used to determine an intrinsic property of the target, such as mechanical information of the tubular sputtering target. The sensing element can for instance be a laser interferometer.

In particular embodiments, a sensing element 111 can be used to determine an extrinsic property of the target, for example by detecting the status of the cooling fluid, for example presence thereof. This is a particular example of processes occurring in the zone 302 between the magnet bar structure 101 and the target 200, as illustrated in FIG 2. In particular ultrasonic signals can be used therefor, as they transmit well through most liquids, e.g. water used as cooling fluid, but not through air or vacuum. In case the sensing element 111, being an ultrasonic transducer, does not read a signal, it can be considered that space between the tubular target 200 and the magnet bar structure 101 has not yet been filled with coolant, hence the target is not ready for being used, or there is a leak or air bubbles somewhere, such that the target, if used further, might be damaged or even destroyed.

In particular embodiments, a sensing element 111 can be used to determine another extrinsic property of the target, e.g. movement, such as rotational speed thereof. In state of the art sputter magnetron systems, often measurements are performed on the axis of the motor driving the target for rotation. However, in such cases, if a gear breaks, the sensor still measures movement, while in reality the target is not rotating and hence will be locally consumed very fast. Measuring the movement, e.g. rotational speed, of the target by means of a sensing device on the magnet bar structure in accordance with embodiments of the present invention, will allow to more accurately determine whether the target is still rotating, in particular in case of gear breakage.

In particular embodiments, a sensing element 111 can be used to sense another extrinsic property of the target, e.g. heat transfer of the target, Hereto, the cooling fluid temperature at both extremities of the magnet bar structure (i.e. at both extremities of the target), can be measured, for instance by means of thermocouples, and the cooling fluid flow can be measured, for instance by means of a flow meter, and, while knowing the specific heat capacity of the cooling fluid, the amount of energy absorbed by the cooling fluid can be calculated. This is another particular example of processes occurring in the zone 302 between the magnet bar structure 101 and the target 200, as illustrated in FIG 2.

In particular embodiments, a sensing element 111 can be used to sense another extrinsic property of the target, e.g. the outer surface condition of the target. This is an example of processes occurring in the zone 301 surrounding the outer surface of the target 200, as illustrated in FIG 2. The surface reactivity of the target will change the SEEY (secondary electron emission yield); thus changing the impedance of the plasma and the target potential. In accordance with this embodiment, the target potential may be measured from a location on the magnet bar when the electrical conductivity of the cooling fluid is known. Alternatively, a change of surface morphology may change the shape of the reflection peak from an ultrasonic transducer. This latter one requires high resolution signals.

In particular embodiments, a sensing element 111 can be used to sense another extrinsic property of the target, e.g. pressure load. The pressure load may be due to pressure from the cooling fluid acting on the target, or vacuum acting on the target. To measure the pressure load, a pressure sensor may be used. If, for instance, the pressure of the cooling fluid is too high, it may impact sealing integrity, or it may even expand and thus deform a thin target tube.

In particular embodiments, a sensing element 111 can be used to sense another extrinsic property of the target, e.g. a number of rotations of the target. Hereto, a photoelectric sensor or a proximity sensor can be used. Alternatively or on top thereof, also the number of coating processes can be sensed. This can for instance be sensed by monitoring the ON and OFF switching of the power on the target tube.

In particular embodiments, a sensing element 111 can be used to sense other extrinsic properties of the target, e.g. the sensing element can sense and log process data during target operation, which are relevant to the target status and/or quality. For instance, the sensing element can sense how long and/or under which processing conditions the target has been used. These sensed values can then be stored on or with the target. Furthermore, it is common that after each coater vent and pump action, the targets have to be reconditioned. Power is ramped according to a specific process flow and according to specific conditions (e.g. only increase the power level if the arcing rate is below a predetermined threshold). Once the power is at its nominal value, some targets need conditioning in reactive mode to get a controlled poisoning state and to deliver stable sputter quality and good layers (this may take several hours). A sensing element used in accordance with embodiments of the present invention can sense such process data as is relevant to the status of the target, and this data can be stored on the target for readout and further use.

In accordance with embodiments of the present invention, sensing intrinsic and/or extrinsic properties of a tubular sputtering target may be performed during rotation of the target or during standstill. Sensing from a rotational tubular target can present additional advantages, as the rotation allows increasing the sensed area of the tubular target. Also, additional information relating to the shape of the tubular target can be retrieved by allowing rotation thereof.

FIG 3 shows a cross section of a tubular target 200 and magnet bar structure 101, the cross section showing the sensing device 110 comprising a sensing element 111 (the viewing angle of the sensing element is represented with dashed lines). In the embodiment illustrated, the sensing element 111 is placed diametrically opposing the magnets 103, thus providing enough space for the sensing element and/or device, without impeding correct functioning of the magnets 102, but other positioning is possible. The possibility of rotating the target, for example after installation or during use, may advantageously allow obtaining information of the quality of the target 200 along a transversal cross section thereof, at the position where the sensing element 111 is placed, rather than only at the region of the inner surface 201 in front of the sensing element integrated in the magnet bar structure, which would be the case at standstill. Hence, a single sensing element 111 at a predetermined position of the magnet bar structure 101 is enough to obtain information from the whole cross section of the tubular target 200 at that position.

In some embodiments of the present invention, a sensing element 111 may give an estimation of the geometry of the target 200; for example it may measure one or more parameters of the shape of the target. For example, it may sense whether the cross section of the tubular target is regular or has an elliptical shape, or whether the target is bent or when the material is of uneven thickness along the circumference. Some of the measurements can be done by detecting differences in the distance between the magnet bar structure and the inner surface of the target during a rotation.

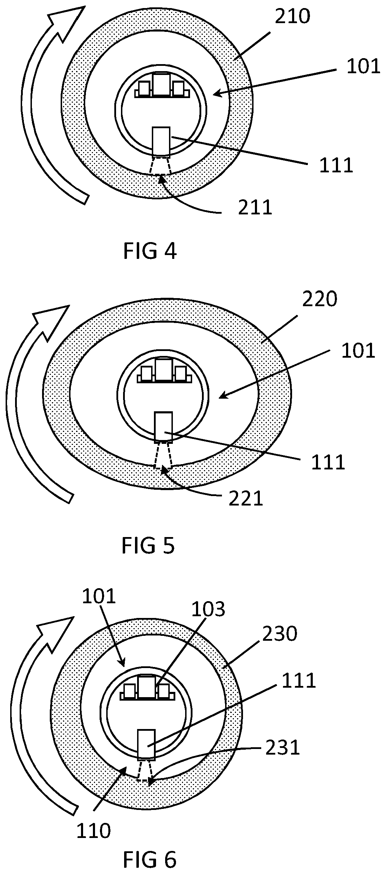

More in detail, FIG 4 and FIG 5 show exemplary embodiments of a sensing element 111 for detecting proximity of the inner surface 211, 221 of deformed targets 210, 220, in particular for the case of a bent target 210 in FIG 4 and for the case of a crushed target 220 with oval cross-section in FIG 5. These deformations may occur during storage and/or transport, for example. A bent target 210 shows a degree of curvature in the longitudinal direction of the tubular sputtering target. During rotation, the distance to the center of the magnet bar structure 101 of a bent target changes. The sensing element 111 will detect a single maximum and a single minimum value of the distance to the inner surface of the target during a 360° rotation of the target, as is seen in the cross section shown in FIG 4. On the other hand, the sensing element 111 sensing the distance to an oval target 220 as in FIG 5 would give a maximum and a minimum value of the distance, twice, during a 360° rotation of the target (or more than two values, if the target is heavily deformed or crushed and bent). It should be noted that the representations in FIG 3, 4, and 5 assume that the magnet bar structure is suspended inside the surrounding target tube and has fixation points only at both extremities. As such, an out of axis movement of the target tube can be detected by the fixed axis magnet bar structure. However, it is known by people skilled in the art that some magnet bar structures may have limited mechanical strength and may contact the inner surface 201 of the target with e.g. brushes or rollers. These magnet bar structures may follow any movement of the target while keeping the distance to the inner surface constant. In this case, a radial or axial deformation of the target tube shape may be monitored by sensing the flexing movement of the magnet bar structure itself. The sensing element may be a single strain gauge or an array of strain gauges, measuring the magnet bar structure deformation. The magnet bar structure may contain a sensing device having a light source 112 (e.g. a laser) and an optical detector (e.g. single array or 2D CMOS or CCD detector) in which each deformation is translated in a shift of the received spot (intensity, shape, position, ...). Other techniques may be used for detecting the impact of the target tube on the magnet bar structure.

Another case is illustrated in FIG 6. A single proximity sensor detecting a varying distance to the inner surface 213 may suggest that the target is bent. Using or combining this measurement with the measurement of an ultrasonic transducer may detect circumferential asymmetric target material thickness. This may be the result of a non-controlled target production process. E.g. in the case of a monolithic material being presented as a slightly bent rod; drilling a straight hole may result in unequal wall thickness of the resulting tube. E.g. in the case of using a slightly bent backing tube, applying material on the backing tube (e.g. casting, thermal spraying, ...) and finishing the target in a milling machine to a straight outer diameter may result in uneven target material thickness as well. A setup according to embodiments of the present invention, as illustrated in FIG 6, may be able detecting any of these cases.

In some embodiments, where the target is conductive, the sensing element 111 may comprise an inductive sensor as proximity sensor for sensing the target roundness. This can be done by monitoring the response of a single proximity sensor while the target is rotating, for example. It is an advantage of using an inductive sensor that electromagnetic induction is used rather than mechanical waves (such as sound waves) in an ultrasonic transducer. An inductive sensor is easier to implement, and easier for defining distance. The electronics are simpler and the accuracy is higher. When using an inductive sensor, a cheaper solution may be obtained. Moreover, the measurement is not impacted by the presence or properties of non-metallic liquids in between the sensor and the target inner surface, so the measurements for the cases of FIG 3 to FIG 5 are independent of the presence of cooling liquid.

The present invention is not limited to inductive sensors for sensing geometry, and optical sensors and/or ultrasonic transducers can also be adapted for sensing geometry of at least the inner surface of the target.

In the particular case of ultrasonic transducer, the echo can be used to obtain the time delay of the signals traveling between the source and the target and/or between the source and different target interfaces, and the change of the time delay during rotation of the target. The time delay can give an estimation of the roundness and symmetry of the tubular target. If the time delay of signals between source and inner surface of the target is constant during a rotation of a tubular cylindrical target, the target has constant inner diameter. If the time delay of signals between source and outer surface of the target is constant during a rotation of a tubular cylindrical target, the target has a constant outer diameter. If both the time delay of signals between source and inner surface, and between source and outer surface of the target are constant during a rotation of the tubular target, the target has an equal thickness over its circumference, at least at the location of measurement. If any of the time delays changes periodically, typically with a frequency corresponding with target rotation speed, then depending on the delayed signal with changes:
- the inner diameter is not concentric with the outer diameter of the target (due to e.g. inaccuracies of fabrication) if the delay of the signals between source and inner surface, or the delay of the signals between source and outer surface changes periodically, while the other one remains constant, so the thickness of the target material is not constant (as illustrated in FIG 6), or
- the target material has oval thickness variation, if the delay of the signals between source and inner surface, or the delay of the signals between source and outer surface presents two maxima and minima during the rotation, while the other one remains constant (not illustrated), or
- the target is crushed, as shown in FIG 5, if the delay of the echo of the first inner surface of the target presents two maxima and minima during one rotation, or
- the target is bowed as shown in FIG 4, if the delay of the echo of the first inner surface changes periodically once per rotation.

Of course, the above list of possible variations in time delays of echoed signals and combinations thereof is not limited, and other combinations can occur, indicating other intrinsic or extrinsic properties of the target.

As indicated before, the sensing device 110 may include a signal transmitter 105 for transmitting the signals sensed from the tubular target 200 as an output to an external unit 106, e.g. a processing unit, a database and/or a display. The transmitter 105 may be wired or wireless. For example, in the case of ultrasonic transducers, the transducer elements may be connected to an external unit (e.g. including a controller) by means of coaxial cables (e.g. having 50 Ohm impedance) functioning as signal transmitter 105.

Signal transmission may be provided in general to outside of the magnet bar structure; thus signals may be sent to a receiver outside of or away from the magnet bar. For example, a sensed signal can be transmitted from the sensing device 110 to a receiver on the end block, but alternatively the sensed signal can be transmitted from the sensing device 110 to a receiver outside of the sputter magnetron system, directly, without using any interconnect on any part of the sputter magnetron system e.g. on the end block, or without transmitting the signal through the end block itself as a transfer medium. In a particular embodiment, the sensor may for instance contain an optical source that uses the cooling liquid as a transfer medium to send the signal to an optical detector.

In other embodiments, a sensed signal may be sent from the sensing device to, for example, a receiver outside the magnet bar, for example to a reader in the end block or a processor in the end block (not pictured), and not necessarily outside the sputter magnetron system.

The external unit 106 (or a processor inside the sputter magnetron system) may provide signal processing. Signal(s) obtained from the sensing element 111 and data processed therefrom may be displayed, for example display of optical signals from a camera, or display of echoes from one or more ultrasonic transducers, etc. The processing unit (e.g. external unit 106) may include a database to store signals from the sensing element and/or data processed from the signals.

The external unit 106 may provide, also via the signal transmitter 105 or via an extra connection (not shown), control of the sensing element 111, for example it may include a user interface that would allow to manually control the activation of sensing device 110, more particularly of one or more of its sensing elements 111. Additionally or alternatively, the activation or the signal capture may be controlled automatically via software from the external unit 106.

The present invention is not limited to sensing the geometric, quality and status parameters of the tubular target. In some embodiments of the present invention, at least one sensing element of the sensing device attached to the magnet bar structure is an identification (ID) reader. The signals and data relate in this case to the identification of the target.

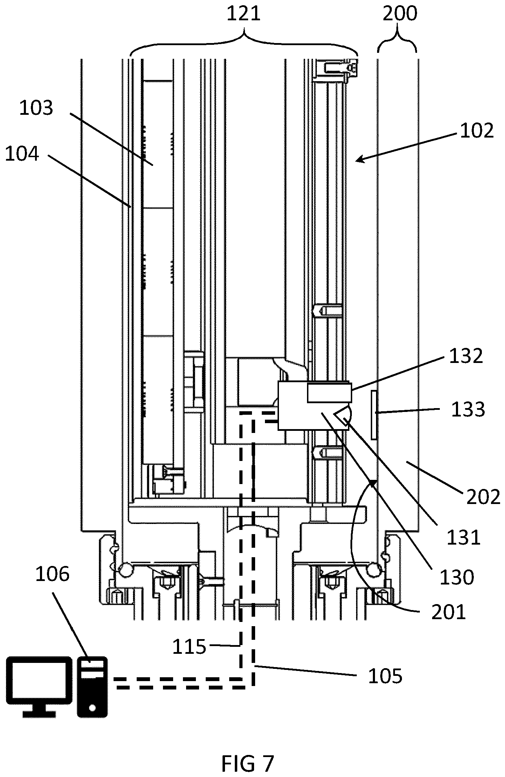

FIG 7 shows an exemplary embodiment of a magnet bar structure 121 including a sensing device 130 having at least one sensing element 131 being an ID reader for reading at least one ID tag 133 of a target 200, for example an ID tag 133 provided on the inner surface 201 of the tubular target 200. For example, the sensing element 131 may comprise an optical reader, and the ID tag 133 may include an optically readable tag. The sensing element 131 may be a scanner for scanning a code on the target, e.g. a laser scanner for reading a bar code, or a 2D scanner for reading a QR code. In some embodiments, the sensing element 131 may be a camera functioning as an ID reader for reading a character string. As before, the magnet bar structure 121 may comprise a signal source 132 (e.g. radiation source, such as light, e.g. laser, laser sheet or the like). The sensing element 131 and any signal source 132 may be included (e.g. integrated) in a sensing device 130 being a reading device.

A signal transmitter 105, for example a data transmission port (wired or wireless) can be included for receiving signals from the sensing element 131, and for transmitting these signals to an external unit 106. Scanned data can be processed and stored in the external unit 106, for example in a database or the like. Alternatively, an image from a camera can be stored and/or digitized and/or displayed using the transmitter 105 and unit 106. For example the image can be digitized, for example by an optical character recognition (OCR) program in the camera or in the external unit 106 which receives input from the camera acting as sensing element 131. The raw image, or the processed and digitized code, can be displayed in the external unit 106 including a display, to display e.g. on a screen the character string scanned or digitized from the ID tag.

The rotation of the target may allow automatic reading of the ID tag 133 with the sensing element 131 integrated in the magnet bar structure 121. Thus, there is no need for an operator to find and write down the label to confirm the identity of the tubular target. In embodiments of the present invention, this can be done after installation, at startup of the magnetron sputtering system and/or at any time during sputtering. After installation, at startup of the magnetron sputtering system and/or at any time during sputtering a mapping of the used target materials may be generated over the complete coating line.

The reading device 130 may include an electric emitter/reader, magnetic emitter/reader, or electromagnetic emitter/reader. For example, the reading device 130 may comprise a transponder tag (for RFID reading), an NFC tag, a magnetic tag, for example in the form of strips or patches (although there may be a potential impact on the plasma confinement during sputtering), or electric pads, optionally connected to a chip.

In the particular example of RFID reading, the magnet bar structure comprises a sensing element 131 for collecting information from radio-frequency identification (RFID) tags 133. The sensing element 131 is in this case an RFID tag reader, which may be an active reader, a passive reader, or may have both functionalities which can be selected according to the type of tag used in the tubular target. Such an RFID tag 133 may be provided on the inner surface 201 of the target 200, or embedded in the backing tube thereof, or in the target material 202 itself.

The RFID system has the advantage that it can be used at any moment, even during sputtering, in a reliable way because the reader (and/or the impedance of the tag) can be tuned for the presence of cooling fluids (e.g. cooling water) between the magnet bar 102 having attached thereto the sensing element 131, and for the tag 133 on the inner surface of, or embedded in, the tubular target 200. It is a further advantage that the RFID tag 133 may be shielded, to avoid direct exposure with cooling fluid, and still being detected by a sensing element 131 acting as RFID reader.

The signal transmitter 105 and external unit 106 explained earlier with reference to optical sensing elements, can be also applied to RFID systems. Signals related to the identity obtained from RFID reading can be stored, or processed into data and stored, optionally also displayed, by means of the external unit 106. Signal transmitter 105 may be wired or wireless, for sending the signals including information data from the RFID tag outside the magnetron sputtering system. Information related to the identity of the target (including composition and the like), as well as the identity of the magnetron sputtering system used, utilization hours and the like, can be logged in a database.

In some embodiments of the present invention, the sensing device 130 may also include a writer; for example an emitter 132 in the sensing device 130 may be adapted to change the information stored in the RFID tag 133. In some embodiments, the sensing element 131 may be an RFID reader/writer, obtaining a highly compact device.

Writability allows a user to introduce information related to usage, incidences and/or dates on a suitable (writable) RFID tag 133 of a tubular target 200, which improves tracking of the tubular target. Hence, the RFID tag 133 of the target 200 may include not only information of the identity (composition, etc.), but also of the status, useful life remaining and incidences during usage, such as vacuum failure, possible poisoning, information related to different magnetron sputtering systems that could have used that particular target during its useful life, sputtering processes in which the target was used, historic data, etc. This would allow classifying the targets in accordance to any suitable criterium, for example classifying them by quality. For example, a used, non-depleted target that may have suffered poisoning can be distinguished from used, non-depleted targets with expected high quality target material.

In embodiments where the reading device 130 (and/or the ID reader 131) is also writer, data input may be included, in order to include information in the RFID tag of the tubular target. Data input may be done through a signal transmitter 115 which may be wired or wireless. Data may be introduced from an external unit 106, including e.g. a user interface or a unit that updates the information of the RFID tag automatically, including incidences and/or time stamps indicating the sputtering start and end times.

In some embodiments of the present invention, the data transmitter 115 for data input is the same as the data transmitter 105 for signal output.

In some embodiments of the present invention, the magnet bar structure 121, more particularly the sensing device 130 attached to the magnet bar 102, may be adapted to sense information from more than one area of the tubular target 200. For instance, a plurality of sensing elements 131 may be included in the sensing device (not shown), spread over the magnet bar 102, for measuring properties at several places of the target. Preferably, the sensing elements 131 are distributed along the length of the elongated magnet bar 102, so the properties or ID of the target 200 can be studied or read along its length and, if sensing is performed during rotation, also along several sections distributed along the length of the target.

In case of having an identification element 133 inside the target, it may be preferred of having it installed closer to an extremity of the target tube. As such, it is easier to apply it at the desired position (e.g. independent of target length) and an operator may extract the data easily with a handheld reader/scanner when the tube is offline or stored.

Additionally or optionally, the magnet bar structure 121 may include an extended sensing element to provide detection along at least part of the length or all of the length of the magnet bar structure. For example, an optical sensor may be adapted to receive signals from the target in a wide area along the length thereof, for example in 20% of the total length from one of the extremes, or from half of the length, or at any position in the whole of the length of the tubular target. For example, a plurality of optical sensors may be laid out along the magnet bar 102.

A magnet bar structure which allows sensing along the length of the tubular target may bring additional advantages:
- Information regarding cracks, thickness, deformation and/or other parameters can be obtained along a substantial part of the target, or even along the whole target.
- In case the sensing element comprises for instance a barcode scanner, the exact position of the barcode tag in the tubular target would not be an important factor, as the magnet bar structure could read the barcode tag at several positions along the length of the tubular target, or even at any position thereof. Thus, the same magnet bar structure could read different targets of different manufacturers, which may have differently positioned barcode tags, or different position of bar codes along the inner surface of the target.
- A plurality of inductive sensors may be used to estimate the amount of deformation, for example bending, along the length of the tubular target.

A magnet bar structure in accordance with some embodiments of the present invention may include ID data retrieval and target quality information retrieval, which can be combined, thus obtaining a complete overview of the identity, history and status of a particular tubular target. A single sensing element 111 may fulfill these requirements of quality and ID information retrieval. For example, a camera can be included for retrieving ID information from a tag (e.g. a character string) and simultaneously sensing the presence of microcracks on the surface of the tubular target. Alternatively, a plurality of sensing elements 111, 131 may be included, at least one specifically adapted for ID retrieval from an ID tag and at least one specifically adapted for quality and/or status measurement on the target (presence of cracks, deformation and asymmetry detection of the tubular target, etc.). Further, including writing capabilities (such as an RFID reader/writer for writing on an RFID tag) also allows transferring at least part of the information of the history and status of the tubular target to the target itself.

In some embodiments of the present invention, all these activities can be performed during sputtering, including data retrieval, data processing, update of information in a database and even writing on a suitable RFID tag in a tubular target.

## Claims

1. A magnet bar structure (101) for a sputter magnetron system, the magnet bar structure (101) comprising a magnet bar (102) and a sensing device (110, 130), wherein the sensing device is attached to the magnet bar structure for sensing intrinsic and/or extrinsic properties of a tubular sputtering target (200, 210, 220) when mounted over the magnet bar structure (101).

2. The magnet bar structure of the previous claim, further comprising signal transmission means (105) for transmitting signals from the sensing device (110,130) to a receiver outside of the magnet bar structure.

3. The magnet bar structure in accordance with any of the previous claims, wherein the sensing device (110) is adapted to sense the presence of cracks and/or pores in the tubular sputtering target (200).

4. The magnet bar structure in accordance with any of the previous claims, wherein the sensing device (110) is adapted to sense the regularity of the inner and/or outer diameter of the tubular sputtering target (220) and/or the curvature in the longitudinal direction of the tubular sputtering target (210).

5. The magnet bar structure in accordance with any of the previous claims, wherein the sensing device (110) comprises an ultrasonic transducer and/or an optical sensor.

6. The magnet bar structure in accordance with any of the previous claims, wherein the sensing device (110) comprises an inductive proximity sensor.

7. The magnet bar structure in accordance with any of the previous claims, wherein the sensing device (110, 130) is adapted for sensing identification information of the tubular sputtering target (200).

8. The magnet bar structure in accordance with claim 7, where the sensing device (110, 130) comprises an optical reader for reading a bar code (133) on the tubular sputtering target (200).

9. The magnet bar structure in accordance with any of claims 7 or 8 wherein the sensing device (110, 130) is an identification reader for reading an identification tag (133).

10. The magnet bar structure in accordance with claim 9, wherein the identification reader is a radio-frequency identification reader/writer, the magnet bar structure (101) further comprising means (105, 115) for receiving signals from the outside of the sputter magnetron system for writing and/or overwriting a radio-frequency identification tag.

11. The magnet bar structure in accordance with any of the previous claims, wherein the sensing device (110) comprises a temperature sensor.

12. The magnet bar structure in accordance with any of the previous claims, wherein the sensing device (110) comprises one or more of a strain gauge and/or a CCD array.

13. The magnet bar structure in accordance with any one of the previous claims, wherein the sensing device (110, 130) comprises a plurality of sensing elements (111, 131) of same or different type.

14. The magnet bar structure in accordance with claim 13, wherein the magnet bar structure (101) is elongated in a longitudinal direction, and the plurality of sensing elements (111, 131) are distributed along said longitudinal direction.

## Patentansprüche

1. - Magnetstangenstruktur (101) für ein Sputtermagnetron-System, wobei die Magnetstangenstruktur (101) eine Magnetstange (102) und eine Sensorvorrichtung (110, 130) umfasst, wobei die Sensorvorrichtung an der Magnetstangenstruktur zum Erfassen von intrinsischen und/oder extrinsischen Eigenschaften eines röhrenförmigen Sputtering-Ziels (200, 210, 220) befestigt ist, wenn es über der Magnetstangenstruktur (101) montiert ist.

2. - Magnetstangenstruktur nach dem vorstehenden Anspruch, weiter Signalübertragungsmittel (105) zum Übertragen von Signalen aus der Sensorvorrichtung (110,130) an einen Empfänger außerhalb der Magnetstangenstruktur umfassend.

3. - Magnetstangenstruktur nach einem der vorstehenden Ansprüche, wobei die Sensorvorrichtung (110) angepasst ist, um das Vorhandensein von Rissen und/oder Poren in dem röhrenförmigen Sputtering-Ziel (200) zu erfassen.

4. - Magnetstangenstruktur nach einem der vorstehenden Ansprüche, wobei die Sensorvorrichtung (110) angepasst ist, um die Gleichmäßigkeit des Innen- und/oder Außendurchmessers des röhrenförmigen Sputtering-Ziels (220) und/oder die Krümmung in der Längsrichtung des röhrenförmigen Sputtering-Ziels (210) zu erfassen.

5. - Magnetstangenstruktur nach einem der vorstehenden Ansprüche, wobei die Sensorvorrichtung (110) einen Ultraschallwandler und/oder einen optischen Sensor umfasst.

6. - Magnetstangenstruktur nach einem der vorstehenden Ansprüche, wobei die Sensorvorrichtung (110) einen induktiven Näherungssensor umfasst.

7. - Magnetstangenstruktur nach einem der vorstehenden Ansprüche, wobei die Sensorvorrichtung (110, 130) zum Erfassen von Identifizierungsinformationen des röhrenförmigen Sputtering-Ziels (200) angepasst ist.

8. - Magnetstangenstruktur nach Anspruch 7, wobei die Sensorvorrichtung (110, 130) ein optisches Lesegerät zum Lesen eines Strichcodes (133) auf dem röhrenförmigen Sputtering-Ziel (200) umfasst.

9. - Magnetstangenstruktur nach einem der Ansprüche 7 oder 8, wobei die Sensorvorrichtung (110, 130) ein Identifizierungslesegerät zum Lesen eines Identifizierungsetiketts (133) ist.

10. - Magnetstangenstruktur nach Anspruch 9, wobei das Identifizierungslesegerät ein Funkfrequenz-Identifizierungslese-/schreibgerät ist, wobei die Magnetstangenstruktur (101) weiter Mittel (105, 115) zum Empfangen von Signalen von außerhalb des Sputtermagnetron-Systems zum Schreiben und/oder Überschreiben eines Funkfrequenz-Identifizierungsetiketts umfasst.

11. - Magnetstangenstruktur nach einem der vorstehenden Ansprüche, wobei die Sensorvorrichtung (110) einen Temperatursensor umfasst.

12. - Magnetstangenstruktur nach einem der vorstehenden Ansprüche, wobei die Sensorvorrichtung (110) eines oder mehrere von einem Dehnmessstreifen und/ oder einer CCD-Anordnung umfasst.

13. - Magnetstangenstruktur nach einem der vorstehenden Ansprüche, wobei die Sensorvorrichtung (110, 130) eine Vielzahl von Sensorelementen (111, 131) einer selben oder unterschiedlichen Art umfasst.

14. - Magnetstangenstruktur nach Anspruch 13, wobei sich die Magnetstangenstruktur (101) in einer Längsrichtung erstreckt, und die Vielzahl von Sensorelementen (111, 131) entlang der Längsrichtung verteilt sind.

## Revendications

1. - Une structure de barre magnétique (101) pour un système de magnétron de pulvérisation, la structure de barre magnétique (101) comprenant une barre magnétique (102) et un dispositif de détection (110, 130), dans laquelle le dispositif de détection est fixé à la structure de barre magnétique pour détecter des propriétés intrinsèques et/ou extrinsèques d'une cible de pulvérisation tubulaire (200, 210, 220) lorsqu'elle est montée sur la structure de barre magnétique (101).

2. - La structure de barre magnétique selon la revendication précédente, comprenant en outre des moyens de transmission de signal (105) pour transmettre des signaux du dispositif de détection (110, 130) à un récepteur à l'extérieur de la structure de barre magnétique.

3. - La structure de barre magnétique selon l'une quelconque des revendications précédentes, dans laquelle le dispositif de détection (110) est adapté pour détecter la présence de fissures et/ou de pores dans la cible de pulvérisation tubulaire (200).

4. - La structure de barre magnétique selon l'une quelconque des revendications précédentes, dans laquelle le dispositif de détection (110) est adapté pour détecter la régularité du diamètre intérieur et/ou extérieur de la cible de pulvérisation tubulaire (220) et/ou la courbure dans la direction longitudinale de la cible de pulvérisation tubulaire (210).

5. - La structure de barre magnétique selon l'une quelconque des revendications précédentes, dans laquelle le dispositif de détection (110) comprend un transducteur à ultrasons et/ou un capteur optique.

6. - La structure de barre magnétique selon l'une quelconque des revendications précédentes, dans laquelle le dispositif de détection (110) comprend un capteur de proximité inductif.

7. - La structure de barre magnétique selon l'une quelconque des revendications précédentes, dans laquelle le dispositif de détection (110, 130) est adapté pour détecter des informations d'identification de la cible de pulvérisation tubulaire (200).

8. - La structure de barre magnétique selon la revendication 7, dans laquelle le dispositif de détection (110, 130) comprend un lecteur optique pour lire un code à barres (133) sur la cible de pulvérisation tubulaire (200).

9. - La structure de barre magnétique selon l'une quelconque des revendications 7 ou 8, dans laquelle le dispositif de détection (110, 130) est un lecteur d'identification pour lire une étiquette d'identification (133).

10. - La structure de barre magnétique selon la revendication 9, dans laquelle le lecteur d'identification est un lecteur/enregistreur d'identification par radiofréquence, la structure de barre magnétique (101) comprenant en outre des moyens (105, 115) pour recevoir des signaux de l'extérieur du système de magnétron de pulvérisation pour écrire et/ou écraser une étiquette d'identification par radiofréquence.

11. - La structure de barre magnétique selon l'une quelconque des revendications précédentes, dans laquelle le dispositif de détection (110) comprend un capteur de température.

12. - La structure de barre magnétique selon l'une quelconque des revendications précédentes, dans laquelle le dispositif de détection (110) comprend un ou plusieurs d'une jauge de contrainte et/ou d'un réseau CCD.

13. - La structure de barre magnétique selon l'une quelconque des revendications précédentes, dans laquelle le dispositif de détection (110, 130) comprend une pluralité d'éléments de détection (111, 131) d'un type identique ou différent.

14. - La structure de barre magnétique selon la revendication 13, dans laquelle la structure de barre magnétique (101) est allongée dans une direction longitudinale, et la pluralité d'éléments de détection (111, 131) sont répartis le long de ladite direction longitudinale.
